# EUROPEAN PATENT SPECIFICATION

(11) **EP 4 106 017 B1**
(45) Date of publication and mention of the grant of the patent: **14.02.2024**
(21) Application number: 21382540.9
(22) Date of filing: 18.06.2021
(51) Int. Cl.: H01L 31/05, H01L 31/052, H02S 40/34, H02S 40/42

(54) **COOLING SYSTEM FOR A PHOTOVOLTAIC SOLAR PANEL**
KÜHLSYSTEM FÜR EIN FOTOVOLTAISCHES SOLARPANEEL
SYSTÈME DE REFROIDISSEMENT POUR UN PANNEAU SOLAIRE PHOTOVOLTAÏQUE

(43) Date of publication of application: 21.12.2022
(73) Proprietor: Soltec Innovations, S.L., 30500 Molina de Segura (ES)
(72) Inventor: Torrano Carrillo, Francisco Javier, 30500 Murcia (ES)
(74) Representative: Isern Patentes y Marcas S.L.

(56) References cited:
- WO-A2-2009/151251
- CN-A- 111 669 122
- CN-U- 207 265 978
- US-A1- 2017 104 446

## Description

### Technical field of the invention

The present invention may be included within the technical field of solar energy. In particular, the object of the invention relates to a cooling system for cooling photovoltaic solar panel(s).

### Background of the invention

A photovoltaic solar panel comprises photovoltaic cells, for transforming sun radiation into electrical energy. The energy from the cells is gathered by conductors referred to as "fingers", usually made of copper, which transport the energy to busbars, also usually made of copper, which interconnect the cells in series and in parallel, so as to form one or several strings in a solar module.

The efficiency of a photovoltaic solar panel is strongly affected by the temperature of the photovoltaic cell during operation, wherein each 1 °C of deviation with respect to NOTC (Nominal Operating Cell Temperature) causes a loss of power extracted from the cell of 0.3 - 0.35 %. Since NOTC is usually about 45 °C and the operating temperature often reaches around 65 °C under a 1000 W/m² radiation and an ambient temperature of 35 °C (which is often the case in desertic or and locations where great photovoltaic installations take place), the loss of power is significant due to an excess temperature of the photovoltaic cell.

Documents, such as CN207265978, are known, describing solutions for photovoltaic module cooling systems, wherein one or several heat exchangers are mounted on a rear part of the module for cooling the module. These solutions have the drawbacks that the cooling system shares a valuable space with the solar panels, so that shadowing of the panels is produced.

Documents CN111669122A (LU LINDI), WO2009/151251A2 (KIM SONG-TAE), US2017/104446A1 (SAKABE MOTOYA) and CN207265978U (ANHUI DAHENG ENERGY) disclose cooling systems for photovoltaic solar panels according to the preamble of independent claim 1.

### Summarized description of the invention

The present invention provides a cooling system for cooling the busbar(s) of a photovoltaic solar panel, according to independent claim 1.

The cooling system comprises heat exchangers in contact to the busbars, because, due to the thermal conductivity of the busbars, cooling the busbars results in cooling the whole solar panel.

The cooling system of the invention limits the shadows provided by refrigeration equipment, and is applicable to both monofacial and bifacial photovoltaic panels.

### Brief description of the drawings

All preceding, as well as other, features and advantages, shall be better understood in the light of the following detailed description of preferred embodiments of the invention, with reference to the attached drawings, which are to be considered for illustrative, non-limiting purposes, and wherein:
- Figure 1 shows a perspective view of an arrangement of the heat exchangers according to a first preferred embodiment.
- Figure 2 shows a schematic perspective view of an arrangement of a refrigeration means according to a first example of the first preferred embodiment.
- Figure 3 shows a schematic perspective view of an arrangement of a refrigeration means according to a second example of the first preferred embodiment.
- Figure 4 shows a perspective view of an arrangement of the heat exchangers according to a second preferred embodiment.
- Figure 5 shows a flow chart of a first example of refrigeration means for the second preferred embodiment.
- Figure 6 shows a flow chart of a second example of refrigeration means for the first and the second preferred embodiments.

### Detailed description of a preferred embodiment of the invention

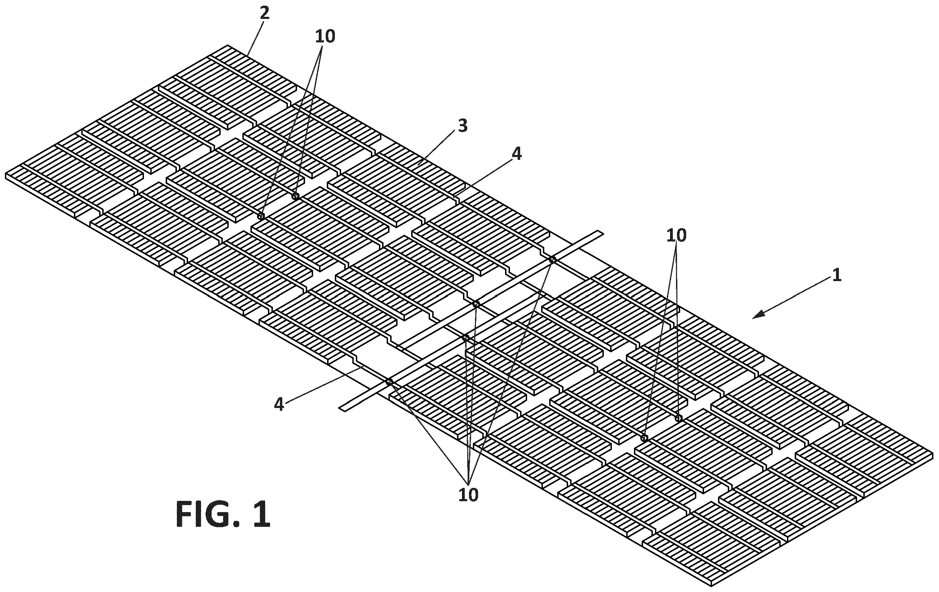

Next, a detailed description of preferred embodiments of the invention is provided with the help of above-mentioned figures 1-6.

The cooling system of the invention is intended to be applied to a solar installation comprising one or several photovoltaic solar panels (1), the panels (1) comprising: photovoltaic cells (2); fingers (3) for gathering electricity from the cells (2); and one or several busbars (4) for grouping the electricity gathered by the fingers (3) and interconnecting the cells (2).

The cooling system comprises at least one heat exchanger (5, 6) in contact with the at least one busbar (4) of one or several of the solar panels (1). Due to the high heat conductivity of the busbar(s) (4), heat is easily transferred from the busbar(s) (4) to the heat exchanger(s) (5, 6). The cooling system further comprises refrigeration means (7, 8, 9) for retiring the heat from the heat exchangers (5, 6) to an ambient.

Next, two preferred embodiments of the heat exchangers (5, 6) are described. For each preferred embodiment, two preferred examples of refrigeration means (7, 8, 9) are described.

### EMBODIMENT 1: DISCRETE COOLING

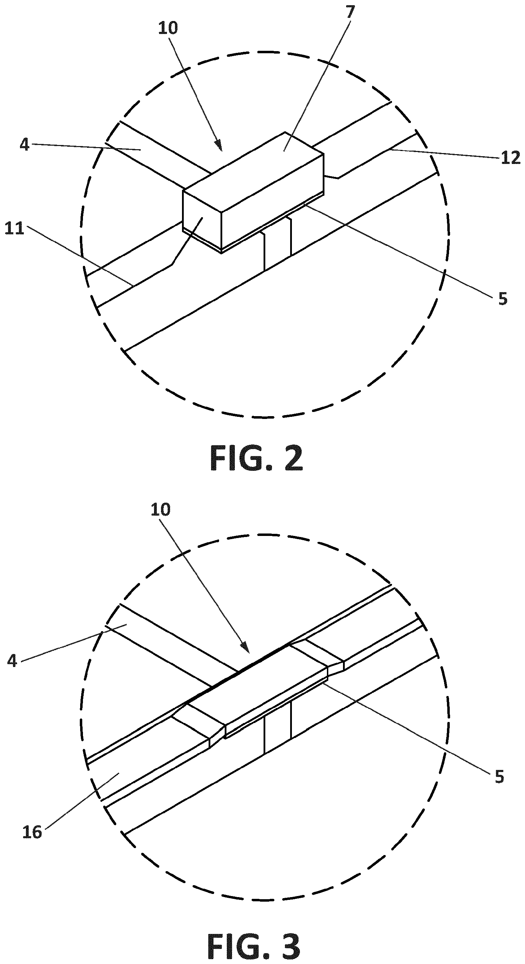

In this first preferred embodiment, according to figure 2, a number of electrically insulant heat exchangers (5) are provided in several discrete locations (10) i.e., points of the busbar(s) (4). The electrically insulant heat exchangers (5) may be any kind of conventional, commercially available heat exchangers (5), such as, for instance, thermal pads.

The refrigeration means (7, 8, 9) for the first embodiment may comprise, as a first example thereof, see figure 2, one or several thermoelectrical refrigerating elements (7), in contact to the electrically insulant heat exchangers (5), operating according to the Peltier effect, and electrically powered through a positive conductor (11) and a negative conductor (12) of a power source (not shown). The power source may be fed by a part of the energy provided by the panel (1) itself, by including corresponding current-conditioning elements, such as commercially available DC/DC converters.

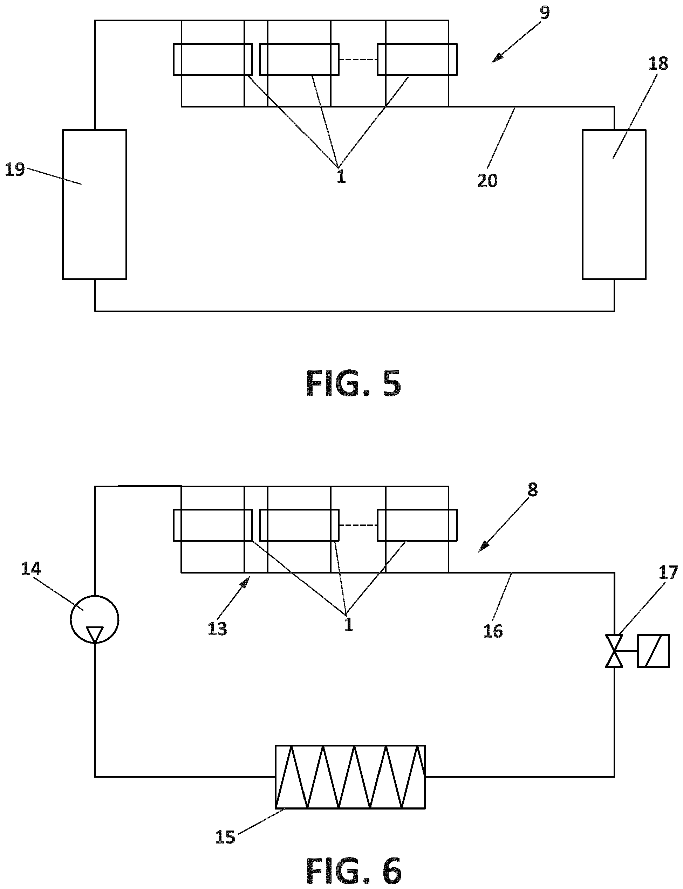

A second example of refrigeration means (7, 8, 9) for the first embodiment relates, see figures 3 and 6, to a refrigerating machine (8) operating through a Reverse Carnot Cycle or, more accurately, through a simple mechanical vapor-compression refrigerating machine, wherein the refrigerating machine (8) comprises:
- an evaporator (13), including all the heat exchangers (5, 6);
- a compressor (14);
- a condenser (15);
- refrigerating ducts (16) through which a cooling fluid flows; and
- an expansion valve (17) located on the refrigerating ducts (16).

### EMBODIMENT 2: CONTINUOUS COOLING

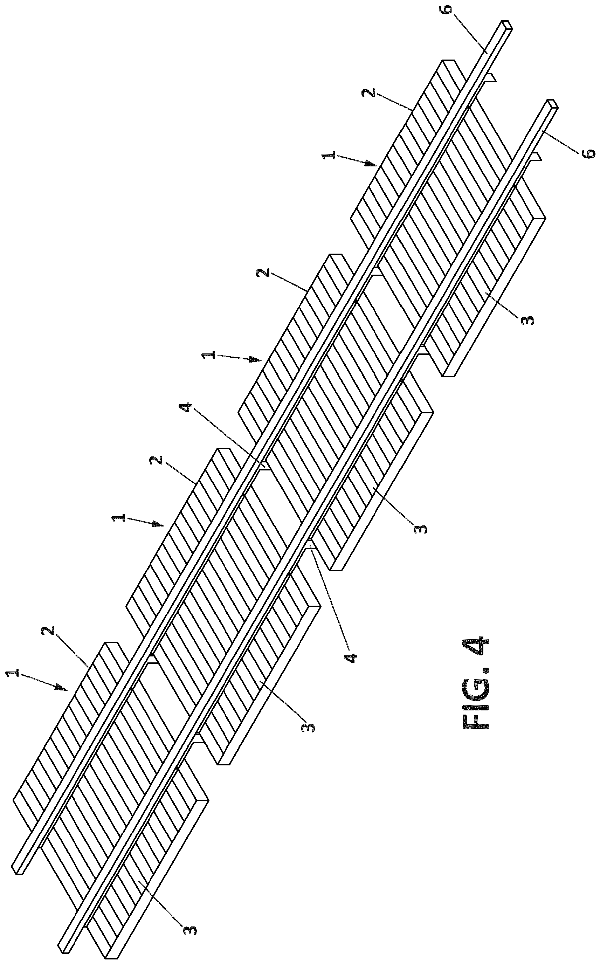

In this second preferred embodiment, according to figure 4, the heat exchangers (5, 6) comprise one or several exchanging ducts (6) located along, and in contact to, the busbar(s) (4) or portions thereof. Preferably the exchanging ducts (6) have a width equal to that of the busbar(s) (4). A cooling fluid flows within the exchanging ducts (6).

The refrigeration means (7, 8, 9) for the second embodiment may comprise, as a first example thereof, see figure 5, natural-convection refrigeration means (9). In this case, the natural-convection refrigerating means (9) comprises a dissipation, colder deposit (18) for the cooling fluid (20) and a hotter deposit (19) for the cooling fluid (20), wherein the cooling fluid (20) flows from the hotter deposit (19) to the colder deposit (18) due to natural convection produced by temperature difference of the deposits (18, 19).

According to a second example, see figures 5 and 6, the refrigeration means (7, 8, 9) of the second embodiment, may be the refrigerating machine (8) as explained above for the second example of the first embodiment, wherein, in both cases, an impulse system (not shown) for impulsing the cooling fluid is connected in parallel to the refrigerating ducts (16), so that the cooling fluid enters at one same initial temperature in all the refrigerating ducts (16). One same impulse system may feed cooling fluid for one or several photovoltaic panels (1). The panel (1) itself may fed the impulse system, through a corresponding current conditioning, as explained above for the power source.

## Claims

1. Cooling system for cooling a photovoltaic solar panel (1), the panel (1) being of the kind comprising:
- photovoltaic cells (2);
- fingers (3) for gathering electrical energy from the photovoltaic cells (2);
- at least one busbar (4) for grouping the electricity gathered by the fingers (3) and interconnecting the photovoltaic cells (2);
the cooling system comprising:
- at least one heat exchanger (5, 6) for receiving heat from the busbar (4) by conductivity; and
- refrigeration means (7, 8, 9) for retiring the heat from the heat exchanger(s) (5, 6) to an ambient;
the cooling system being **characterized in that** the at least one heat exchanger is in contact with the at least one busbar (4) of the solar panel (1).

2. Cooling system according to claim 1, wherein the heat exchangers (5, 6) comprise a plurality of electrically insulant heat exchangers (5) provided in several discrete locations (10), i.e., points, of the busbar(s) (4).

3. Cooling system according to claim 2, wherein the refrigeration means (7, 8, 9) comprise one or several thermoelectrical refrigerating elements (7), in contact to the electrically insulant heat exchangers (5), operating according to the Peltier effect, and electrically powered through a positive conductor (11) and a negative conductor (12) of a power source.

4. Cooling system according to claim 1, wherein the heat exchangers (5, 6) comprise:
- one or several exchanging ducts (6) located along, and in contact to, the busbar(s) (4) or portions thereof; and
- a cooling fluid flowing within the exchanging duct(s) (6).

5. Cooling system according to claim 4, wherein the exchanging duct(s) (6) have a width equal to that of the busbar(s) (4).

6. Cooling system according to any of claims 4-5, wherein the refrigeration means (7, 8, 9) comprises a natural-convection refrigeration means (9) comprising:
- a dissipation, colder (18) deposit for cooling fluid (20); and
- a hotter deposit (19) for the cooling fluid (20), wherein the cooling fluid (20) flows from the hotter deposit (19) to the colder deposit (18) due to natural convection produced by temperature difference of the deposits (18, 19).

7. Cooling system according to any of claims 2, 4 or 5, wherein the refrigeration means (7, 8, 9) comprise a refrigerating machine (9) including:
- an evaporator (13), including all the heat exchangers (5, 6);
- a compressor (14);
- a condenser (15);
- refrigerating ducts (16) through which a cooling fluid (20) flows; and
- an expansion valve (17).

8. Cooling system according to claim 7, wherein an impulse system for impulsing the cooling fluid is connected in parallel to the refrigerating ducts (16), so that the cooling fluid enters at one same initial temperature in all the refrigerating ducts (16).

9. Cooling system according to any of claims 4-8, wherein the cooling fluid comprises Sulphur hexafluoride SF6.

10. Photovoltaic solar installation comprising the cooling system of anyone of claims 1-9.

11. Photovoltaic solar installation according to claim 10, the installation comprising more than one photovoltaic solar panel (1), further comprising an impulse system for impulsing the cooling fluid, the impulse system being connected in parallel to the refrigerating ducts (16), so that the cooling fluid enters at one same initial temperature in all the refrigerating ducts (16), wherein the impulse system feeds cooling fluid for more than one of the photovoltaic panels (1).

## Patentansprüche

1. Kühlsystem zum Kühlen eines photovoltaischen Solarpaneels (1), wobei das Paneel (1) von der Art ist, die umfasst:
- photovoltaische Zellen (2);
- Finger (3) zum Sammeln elektrischer Energie aus den photovoltaischen Zellen (2);
- mindestens eine Sammelschiene (4) zum Gruppieren der durch die Finger (3) gesammelten Elektrizität und zum Verbinden der photovoltaischen Zellen (2); wobei das Kühlsystem umfasst:
- mindestens einen Wärmetauscher (5, 6) zum Aufnehmen von Wärme von der Sammelschiene (4) durch Leitfähigkeit; und
- Kühlmittel (7, 8, 9) zum Abführen der Wärme aus dem/den Wärmetauscher(n) (5, 6) in die Umgebung;
wobei das Kühlsystem **dadurch gekennzeichnet ist, dass** der mindestens eine Wärmetauscher mit der mindestens einen Sammelschiene (4) des Solarpaneels (1) in Kontakt steht.

2. Kühlsystem nach Anspruch 1, wobei die Wärmetauscher (5, 6) eine Vielzahl von elektrisch isolierenden Wärmetauschern (5) umfassen, die an mehreren diskreten Stellen (10), d. h. Punkten, der Sammelschiene(n) (4) bereitgestellt sind.

3. Kühlsystem nach Anspruch 2, wobei die Kühlmittel (7, 8, 9) ein oder mehrere thermoelektrische Kühlelemente (7) umfassen, die in Kontakt mit den elektrisch isolierenden Wärmetauschern (5) stehen, nach dem Peltier-Effekt arbeiten und über einen positiven Leiter (11) und einen negativen Leiter (12) einer Stromquelle mit Strom versorgt werden.

4. Kühlsystem nach Anspruch 1, wobei die Wärmetauscher (5, 6) umfassen:
- einen oder mehrere Austauschkanäle (6), die entlang der Sammelschiene(n) (4) oder Abschnitten davon angeordnet sind und mit diesen in Kontakt stehen; und
- ein Kühlfluid, das innerhalb der Austauschkanäle (6) strömt.

5. Kühlsystem nach Anspruch 4, wobei der Austauschkanal/die Austauschkanäle (6) eine Breite aufweist/aufweisen, die der der Sammelschiene(n) (4) entspricht.

6. Kühlsystem nach einem der Ansprüche 4 bis 5, wobei die Kühlmittel (7, 8, 9) Kühlmittel (9) mit natürlicher Konvektion umfassen, die umfassen:
- ein ableitendes, kälteres Depot (18) für Kühlfluid (20); und
- ein heißeres Depot (19) für das Kühlfluid (20), wobei das Kühlfluid (20) aufgrund natürlicher Konvektion, die durch Temperaturunterschiede der Depots (18, 19) erzeugt wird, von dem heißeren Depot (19) zu dem kälteren Depot (18) strömt.

7. Kühlsystem nach einem der Ansprüche 2, 4 oder 5, wobei die Kühlmittel (7, 8, 9) eine Kältemaschine (9) umfassen, die einschließt:
- einen Verdampfer (13) einschließlich aller Wärmetauscher (5, 6);
- einen Kompressor (14);
- einen Kondensator (15);
- Kühlkanäle (16), durch die ein Kühlfluid (20) strömt; und
- ein Expansionsventil (17).

8. Kühlsystem nach Anspruch 7, wobei parallel zu den Kühlkanälen (16) ein Impulssystem zum Pulsieren des Kühlfluids geschaltet ist, sodass das Kühlfluid in allen Kühlkanälen (16) mit der gleichen Anfangstemperatur eintritt.

9. Kühlsystem nach einem der Ansprüche 4 bis 8, wobei das Kühlfluid Schwefelhexafluorid SF6 umfasst.

10. Photovoltaische Solaranlage, umfassend das Kühlsystem nach einem der Ansprüche 1 bis 9.

11. Photovoltaische Solaranlage nach Anspruch 10, wobei die Anlage mehr als ein photovoltaisches Solarpaneel (1) umfasst und ferner ein Impulssystem zum Pulsieren des Kühlfluids umfasst, wobei das Impulssystem parallel zu den Kühlkanälen (16) geschaltet ist, sodass das Kühlfluid mit der gleichen Anfangstemperatur in alle Kühlkanäle (16) eintritt, wobei das Impulssystem Kühlfluid für mehr als eines der photovoltaischen Paneele (1) zuführt.

## Revendications

1. Système de refroidissement destiné à refroidir un panneau solaire photovoltaïque (1), le panneau (1) étant du genre comprenant :
- des cellules photovoltaïques (2) ;
- des doigts (3) pour collecter de l'énergie électrique depuis les cellules photovoltaïques (2) ;
- au moins une barre omnibus (4) pour regrouper l'électricité collectée par les doigts (3) et interconnecter les cellules photovoltaïques (2) ;
le système de refroidissement comprenant :
- au moins un échangeur de chaleur (5, 6) pour recevoir de la chaleur depuis la barre omnibus (4) par conductivité ; et
- des moyens de réfrigération (7, 8, 9) pour retirer la chaleur depuis le ou les échangeurs de chaleur (5, 6) vers un milieu ambiant ;
le système de refroidissement étant **caractérisé en ce que** l'au moins un échangeur de chaleur est en contact avec l'au moins une barre omnibus (4) du panneau solaire (1).

2. Système de refroidissement selon la revendication 1, dans lequel les échangeurs de chaleur (5, 6) comprennent une pluralité d'échangeurs de chaleur électriquement isolants (5) fournis dans plusieurs localisations discrètes (10), c'est-à-dire, des points, de la ou des barres omnibus (4).

3. Système de refroidissement selon la revendication 2, dans lequel les moyens de réfrigération (7, 8, 9) comprennent un ou plusieurs éléments réfrigérants thermoélectriques (7), en contact avec les échangeurs de chaleur électriquement isolants (5), fonctionnant selon l'effet Peltier, et alimentés électriquement à travers un conducteur positif (11) et un conducteur négatif (12) d'une source d'alimentation.

4. Système de refroidissement selon la revendication 1, dans lequel les échangeurs de chaleur (5, 6) comprennent :
- un ou plusieurs conduits d'échange (6) localisés le long, et en contact avec, la ou les barres omnibus (4) ou des parties de celles-ci ; et
- un fluide de refroidissement s'écoulant au sein du ou des conduits d'échange (6).

5. Système de refroidissement selon la revendication 4, dans lequel le ou les conduits d'échange (6) ont une largeur égale à celle de la ou des barres omnibus (4).

6. Système de refroidissement selon l'une quelconque des revendications 4 à 5, dans lequel les moyens de réfrigération (7, 8, 9) comprennent des moyens de réfrigération à convection naturelle (9) comprenant :
- un dépôt plus froid (18) de dissipation pour du fluide de refroidissement (20) ; et
- un dépôt plus chaud (19) pour le fluide de refroidissement (20), dans lequel le fluide de refroidissement (20) s'écoule depuis le dépôt plus chaud (19) vers le dépôt plus froid (18) en raison d'une convection naturelle produite par une différence de température des dépôts (18, 19).

7. Système de refroidissement selon l'une quelconque des revendications 2, 4 ou 5, dans lequel les moyens de réfrigération (7, 8, 9) comprennent une machine réfrigérante (9) comportant :
- un évaporateur (13), comportant tous les échangeurs de chaleur (5, 6) ;
- un compresseur (14) ;
- un condenseur (15) ;
- des conduits réfrigérants (16) à travers lesquels un fluide de refroidissement (20) s'écoule ; et
- un détendeur (17).

8. Système de refroidissement selon la revendication 7, dans lequel un système d'impulsion pour impulser le fluide de refroidissement est connecté en parallèle aux conduits réfrigérants (16), de sorte que le fluide de refroidissement entre à une même température initiale dans tous les conduits réfrigérants (16).

9. Système de refroidissement selon l'une quelconque des revendications 4 à 8, dans lequel le fluide de refroidissement comprend de l'hexafluorure de soufre SF6.

10. Installation solaire photovoltaïque comprenant le système de refroidissement selon l'une quelconque des revendications 1 à 9.

11. Installation solaire photovoltaïque selon la revendication 10, l'installation comprenant plus d'un panneau solaire photovoltaïque (1), comprenant en outre un système d'impulsion pour impulser le fluide de refroidissement, le système d'impulsion étant connecté en parallèle aux conduits réfrigérants (16), de sorte que le fluide de refroidissement entre à une même température initiale dans tous les conduits réfrigérants (16), dans laquelle le système à impulsion délivre du fluide de refroidissement pour plus d'un des panneaux photovoltaïques (1).
